# EUROPÄISCHE PATENTSCHRIFT

(11) **EP 0 966 761 B1**
(45) Veröffentlichungstag und Bekanntmachung des Hinweises auf die Patenterteilung: **14.06.2006**
(21) Anmeldenummer: 98965104.7
(22) Anmeldetag: 07.12.1998
(51) Int. Cl.: H01L 29/739, H01L 29/06, H01L 27/092

(54) **VERTIKAL IGBT MIT EINER SOI-STRUKTUR**
VERTICAL IGBT WITH AN SOI STRUCTURE
TRANSISTOR VERTICAL BIPOLAIRE A GRILLE ISOLEE POURVU D'UNE STRUCTURE DU TYPE SILICIUM SUR ISOLANT

(30) Priorität: 14.01.1998 DE 19801093
(43) Veröffentlichungstag der Anmeldung: 29.12.1999
(73) Patentinhaber: Infineon Technologies AG, 81669 München (DE)
(72) Erfinder: TIHANYI, Jenö, D-85551 Kirchheim (DE)
(74) Vertreter: Patentanwälte Westphal, Mussgnug & Partner
(86) Internationale Anmeldenummer: PCT/DE1998/003590
(87) Internationale Veröffentlichungsnummer: WO 1999/036963

(56) Entgegenhaltungen:
- EP-A- 0 768 717
- US-A- 5 396 087
- PATENT ABSTRACTS OF JAPAN vol. 014, no. 374 (E-0964), 13. August 1990 -& JP 02 135781 A (NISSAN MOTOR CO LTD), 24. Mai 1990

## Beschreibung

Die Erfindung betrifft einen SOI-IGBT (SOI = Silicon-on-Insulator bzw. Silizium auf Isolator; IGBT = Insulated Gate Bipolar Transistor, Bipolartransistor mit isoliertem Gate), mit einer Kanalzone des einen Leitfähigkeitstyps, und wenigstens einer Zellenzone des anderen Leitfähigkeitstyps, wobei die Kanalzone und die Zellenzone in einer Halbleiterschicht, die auf einer auf einem Halbleiterkörper des einen Leitfähigkeitstyps vorgesehenen Isolatorschicht angebracht ist angeordnet sind.

Ein solcher IGBT, bei dem die Kanalzone und die Zellenzone üder in der Isolatorschicht vorgesehenen Aussparungen mit dem Halbleiterkörper verbunden sind, ist aus der EP-A-0 768 717 bekannt.

Es ist ständiges Ziel, IGBTs hinsichtlich ihrer Spannungsfestigkeit, Robustheit und Integrierbarkeit zu verbessern. So weist beispielsweise ein bestehender IGBT eine Zellenstruktur auf, bei der zwischen p-leitenden Zellen unter einem aus polykristallinem Silizium bestehenden Gate eine n-leitende Oberflächenschicht eingebracht ist.

Aufgabe der vorliegenden Erfindung ist es, einen SOI-IGBT der eingangs genannten Art hinsichtlich seiner Spannungsfestigkeit, Robustheit und Integrierbarkeit weiter zu verbessern.

Diese Aufgabe wird bei einem SOI-IGBT gemäß Anspruch 1 gelöst. Vorteilhafte Ausgestaltungen des erfindungsgemäßen IGBTs ergeben sich aus den Unteransprüchen. Eine integrierte Schaltung mit dem erfindungsgemäßen IGBT ist Gegenstand des unabhängigen Anspruchs 12.

Der erfindungsgemäße SOI-IGBT hat so eine Zellenstruktur, bei der zwischen einem beispielsweise n⁻-leitenden Siliziumsubstrat als Halbleiterkörper und den einzelnen Zellen eine Isolatorschicht mit einer Schichtdicke von beispielsweise 0,1 µm angeordnet ist. In dieser Isolatorschicht befinden sich Aussparungen, wodurch beispielsweise p⁺-leitende Zellenzonen und n⁻-leitende Zwischenzonen in das n⁻-leitende Siliziumsubstrat hineinreichen. Bei geeignet gewählter Dotierungskonzentration in dem n⁻-leitenden Siliziumsubstrat, das eine Schichtdicke von beispielsweise 50 bis 500 µm haben kann, und entsprechend eingestellter Größe der p⁺-leitenden Zellenzone wird durch die Aussparung das Potential der n⁺-leitenden Kanalzone unter dem Gate auf einen niedrigen Wert begrenzt. Die Raumladungszone im n⁻-leitenden Siliziumsubstrat wird unterhalb der n⁺⁻leitenden Kanalzone im Bereich der Aussparung eingeschnürt, so daß die volle Spannungsfestigkeit des n⁻-leitenden Siliziumsubstrates erreicht wird.

Die an die Zellenzone angrenzende Zone, die so zwischen der Zwischenzone und der Zellenzone liegt, hat den gleichen Leitfähigkeitstyp wie die Zellenzone und ist schwächer als diese dotiert. Im obigen Beispiel ist also diese angrenzende Zone p⁻-dotiert. Sie wirkt im Randbereich des IGBTs als "resurf"-Struktur (resurf = reduced surface field, reduziertes Oberflächenfeld) und trägt so zur Spannungsfestigkeit bei.

Gegebenenfalls kann im Randbereich des IGBTs noch eine Feldplatte vorgesehen werden, die mit zunehmendem Abstand vom Rand des Halbleiterkörpers einen stetig oder stufenweise anwachsenden Abstand von dessen Oberfläche aufweist.

Im obigen Beispiel fließt der Löcherstrom durch die Aussparungen in der Isolatorschicht aus dem n⁻-leitenden Halbleitersubstrat heraus in die p⁺-leitenden Zellenzonen. Die Konzentration der Löcher und Elektronen ist im n⁻-leitenden Siliziumsubstrat im leitenden Zustand um so größer, je kleiner die Fläche der Aussparungen zu den p⁺-leitenden Zellenzonen ist, da ein um so größerer Löcher-Konzentrationsgradient notwendig wird, um den Löcherstrom zu führen. Außerdem ist der Spannungsabfall über der Isolatorschicht um so kleiner, je enger die Aussparungen in der Isolatorschicht zu den p⁺-leitenden Zellenzonen sind.

Bei dem erfindungsgemäßen IGBT führt die "eingeschobene" Isolatorschicht mit den Aussparungen zu einer höheren Überflutung des Siliziumsubstrates mit Ladungsträgern. Die an die Zellenzone angrenzende und zwischen dieser und der Zwischenzone gelegene Zone ist vorzugsweise ausgedehnter als der Abstand zwischen zwei Zellenzonen. Dadurch wird die Randstruktur des IGBTs weiter verbessert und erreicht eine Spannungsfestigkeit in der Größenordnung von weit über 600 Volt. Wird zusätzlich noch die Feldplatte angebracht, so bedeutet dies eine weitere Verbesserung in der Spannungsfestigkeit.

Die Kanalzone, die im obigen Beispiel n⁺-leitend ist, kann gegebenenfalls einen Metall- oder polykristallinen Kern enthalten, was zu einer sehr schnellen Rekombination der Ladungsträger führt, so daß praktisch keine Löcher mehr in die p-leitenden Zonen eintreten, was die Robustheit des IGBTs erhöht.

Die Siliziumschicht auf der Isolatorschicht kann eine Schichtdicke von beispielsweise 0,1 bis 5 µm haben, wenn die Isolatorschicht, wie bereits ausgeführt wurde, etwa 0,1 µm dick ist und das Siliziumsubstrat eine Schichtdicke von 50 bis 500 µm hat.

Nachfolgend wird die Erfindung anhand der Zeichnungen näher erläutert. Es zeigen:
- Fig. 1: ein Schnittbild durch ein erstes Ausführungsbeispiel des erfindungsgemäßen SOI-IGBTs,
- Fig. 2: ein Schnittbild durch ein zweites Ausführungsbeispiel des erfindungsgemäßen SOI-IGBTs, bei dem zusätzlich zum Ausführungsbeispiel von Fig. 1 eine Feldplatte vorgesehen ist,
- Fig. 3: ein Schnittbild durch ein drittes Ausführungsbeispiel des erfindungsgemäßen SOI-IGBTs, bei dem im Unterschied zu den Ausführungsbeispielen der Fig. 1 und 2 n⁺-leitende Kanalzonen mit Unterbrechungen versehen sind, und
- Fig. 4: ein Schnittbild durch ein viertes Ausführungsbeispiel des erfindungsgemäßen SOI-IGBTs mit einer integrierten CMOS-Schaltung.

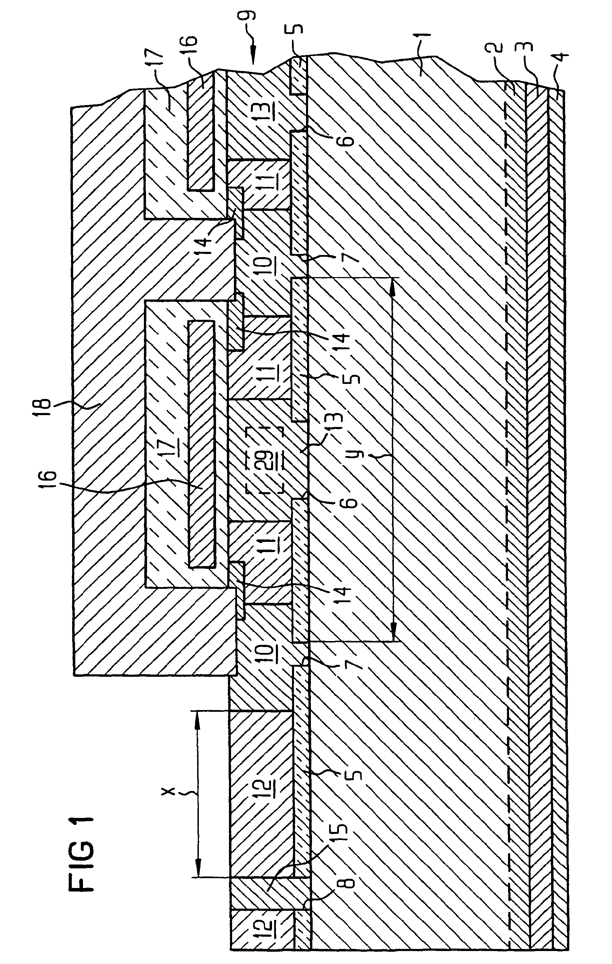

Fig. 1 zeigt ein etwa 100 bis 500 µm dickes Siliziumsubstrat 1, das n⁻-leitend ist und gegebenenfalls eine n⁺-leitende Zone 2 aufweisen kann. An diese Zone 2 bzw. an das Silizium 1 grenzt eine p⁺-leitende Zone 3 an, auf der eine Drainelektrode 4 aus beispielsweise Aluminium aufgebracht ist.

Auf der zur Drainelektrode 4 gegenüberliegenden Seite des Siliziumsubstrates 1 ist eine Isolatorschicht 5 aufgebracht, in der sich Aussparungen 6, 7 und 8 befinden. Auf der Isolatorschicht 5, die eine Schichtdicke von etwa 0,1 µm hat, ist eine Siliziumschicht 9 vorgesehen, die p⁺-leitende Zellenzonen 10, p-leitende Zonen 11, eine p-leitende Randzone 12, eine n⁺-leitende Kanalzone 13, n⁺-leitende Zonen 14 und eine n⁺⁻leitende Zwischenzone 15 enthält.

Oberhalb der Kanalzone 13 ist eine Gateelektrode 16 aus polykristallinem Silizium in eine Isolatorschicht 17, die wie die Isolatorschicht 5 aus beispielsweise Siliziumdioxid oder Siliziumnitrid bestehen kann, eingebettet. Zu den p⁺-leitenden Zonen 10 und zu den Zonen 14 führt eine Source-Metallisierung 18 aus beispielsweise Aluminium.

In die n⁺-leitende Kanalzone 13 kann ein Kern 29 aus Metall oder polykristallinem Silizium eingebettet sein, der für eine rasche Rekombination der Ladungsträger sorgt, so daß in die p-leitenden Zonen 11 praktisch nur noch Elektronen und keine Löcher mehr fließen.

Bei dem erfindungsgemäßen SOI-IGBT wird das Potential der n⁺⁻leitenden Zone 13 unterhalb der Gateelektrode 16 auf einen niedrigen Wert begrenzt. Die Raumladungszone im Siliziumsubstrat 1 wird unterhalb der Aussparung 6 eingeschnürt, so daß das Siliziumsubstrat 1 seine volle Spannungsfestigkeit erreicht.

Die p⁻-leitende Zone 12 im Randbereich wirkt als "resurf"-Struktur und trägt so zur Spannungsfestigkeit bei. Vorzugsweise sollte die Ausdehnung x dieser Zone 12 größer als der Abstand y zwischen zwei benachbarten Aussparungen 7 sein, obwohl dies in der Fig. 1 gerade nicht so dargestellt ist.

Der Löcherstrom fließt aus dem n⁻-leitenden Siliziumsubstrat 1 durch die Aussparungen 7 in die p⁺-leitenden Zonen 10, und die Löcher-Elektronen-Konzentration im n⁻-leitenden Siliziumsubstrat ist um so größer, je kleiner die Fläche dieser Aussparungen 7 ist, da ein um so größerer Löcher-Konzentrationsgradient notwendig ist, um den Löcherstrom zu führen. Außerdem wird der Spannungsabfall um so kleiner, je enger die Aussparungen 7 beieinanderliegen.

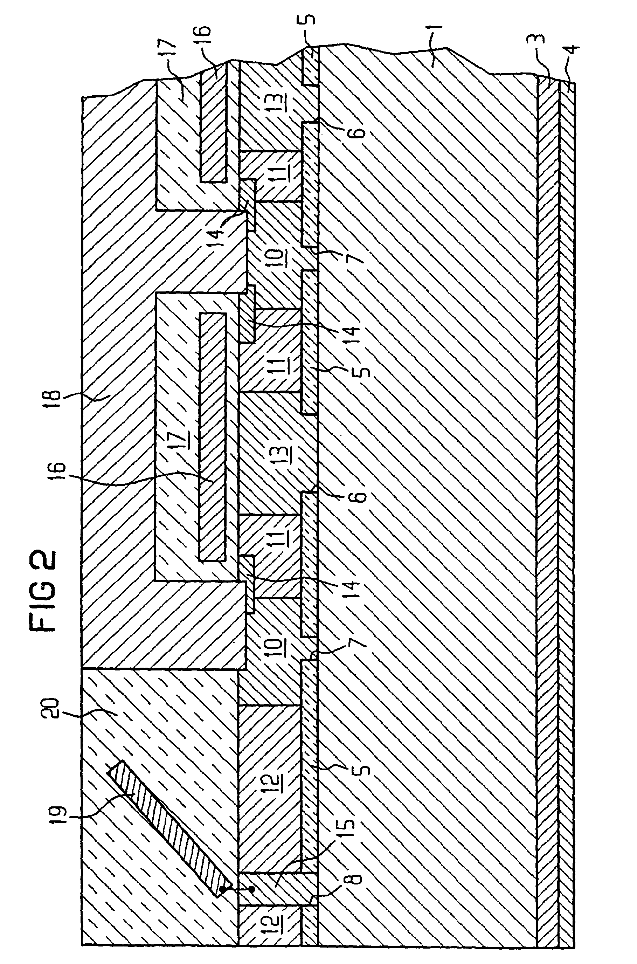

Das Ausführungsbeispiel von Fig. 2 unterscheidet sich von dem Ausführungsbeispiel von Fig. 1 dadurch, daß zusätzlich noch im Randbereich des IGBTs eine Feldplatte 19 in eine Isolatorschicht 20 eingebettet ist und in leitender Verbindung mit der Zwischenzone 15 steht. Diese Feldplatte ist "schräg" gestellt und weist mit steigendem Abstand vom Rand des Siliziumsubstrates 1 eine größere Entfernung von dessen Oberfläche auf. Die Feldplatte kann dabei stetig oder stufenweise ansteigen. Auch ist es möglich, gegebenenfalls mehrere Feldplatten vorzusehen.

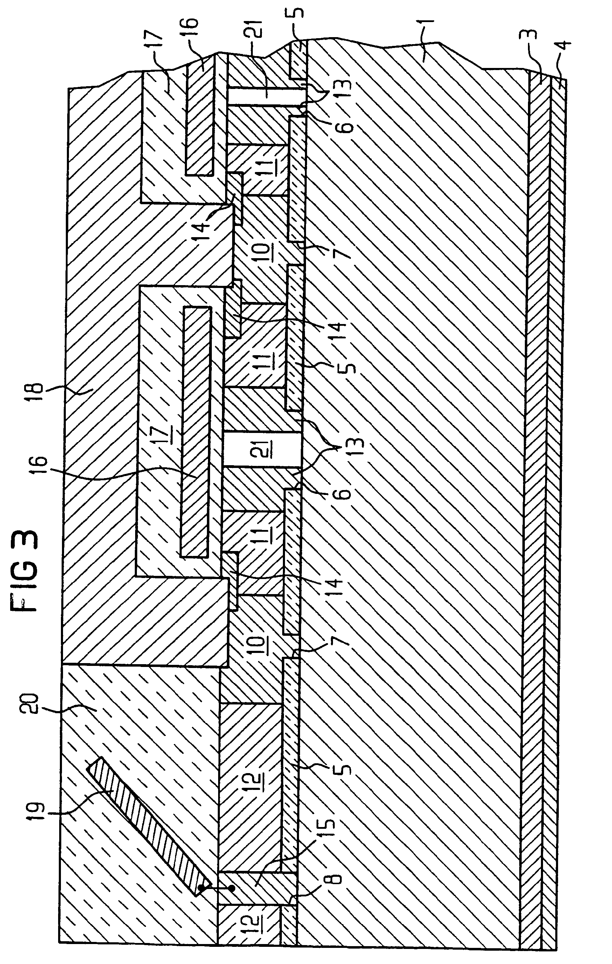

Das Ausführungsbeispiel von Fig. 3 entspricht dem Ausführungsbeispiel von Fig. 2 und unterscheidet sich von diesem dadurch, daß in den n⁺-leitenden Kanalzonen 13 zusätzlich Unterbrechungen 21 vorgesehen sind. Diese Unterbrechungen 21 bestehen aus n⁻-leitendem Silizium und sind also gleich dotiert wie das Siliziumsubstrat 1.

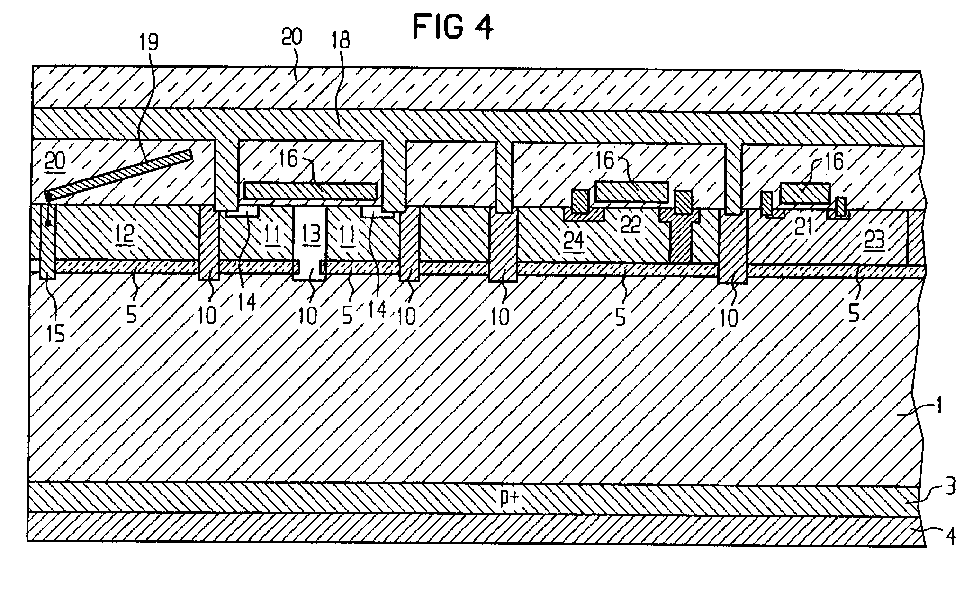

Fig. 4 zeigt ein weiteres Ausführungsbeispiel des erfindungsgemäßen SOI-IGBTs, der hier mit einer CMOS-Schaltung integriert ist. Die CMOS-Schaltung weist zwei komplementäre MOSFETs 21, 22 in einer n-leitenden Wanne 23 bzw. einer p-leitenden Wanne 24 auf. Zwischen den beiden Wannen 23, 24 sind die p⁺-leitenden Zonen 10 von der Source-Metallisierung 18 bis zum Siliziumsubstrat 1 geführt.

## Patentansprüche

1. SOI-IGBT, mit einer Kanalzone (13) des einen Leitfähigkeitstyps, wenigstens einer Zellenzone (10) des anderen Leitfähigkeitstyps und wenigstens einer den IGBT teilweise begrenzenden Zwischenzone (15) des einen Leitfähigkeitstyps, wobei die Kanalzone (13), die Zellenzone (10) und die Zwischenzone (15) in einer Siliziumschicht (9), die auf einer auf einem Halbleiterkörper (1) des einen Leitfähigkeitstyps vorgesehenen Isolatorschicht (5) angebracht ist, angeordnet sind, bei dem die Kanalzone (13), die Zellenzone (10) und die Zwischenzone ; (15) über in der Isolatorschicht (5) vorgesehene, entsprechenden Aussparungen (6, 7, 8) mit dem Halbleiterkörper (1) verbunden sind.

2. SOI-IGBT nach Anspruch 1, **gekennzeichnet durch** eine an die Zellenzone (10) angrenzende Zone (12) des anderen Leitfähigkeitstyps, die im Vergleich zu der Zellenzone (10) schwächer dotiert ist.

3. SOI-IGBT nach Anspruch 2, **gekennzeichnet durch** eine über der angrenzenden Zone (12) angeordnete Feldplatte (19).

4. SOI-IGBT nach Anspruch 3, **dadurch gekennzeichnet, daß** der Abstand zwischen der Feldplatte (19) und dem Halbleiterkörper (1) mit zunehmender Entfernung zu einem Rand des Halbleiterkörpers (1) stetig oder stufenartig zunimmt.

5. SOI-IGBT nach Anspruch 3 oder 4, **dadurch gekennzeichnet, daß** mehrere Feldplatten (19) vorgesehen sind.

6. SOI-IGBT nach einem der Ansprüche 1 bis 5, **gekennzeichnet durch** eine Unterbrechung (21) in der Kanalzone (13), die aus einer Halbleiterzone des einen Leitfähigkeitstyps besteht.

7. SOI-IGBT nach Anspruch 2, **dadurch gekennzeichnet, daß** der Abstand (y) zwischen den Aussparungen (7) von zwei benachbarten Zellenzonen (10) kleiner als die Ausdehnung (x) der angrenzenden Zone (12) ist.

8. SOI-IGBT nach einem der Ansprüche 1 bis 7, **dadurch gekennzeichnet, daß** der Halbleiterkörper ein Siliziumsubstrat (1) mit einer Schichtdicke von 100 bis 500 µm ist.

9. SOI-IGBT nach einem der Ansprüche 1 bis 8, **dadurch gekennzeichnet, daß** die Schichtdicke der die Kanalzone (13), die Zellenzone (10) und die Zwischenzone (15) enthaltenden Siliziumschicht (9) 0,1 bis 5 µm beträgt.

10. SOI-IGBT nach einem der Ansprüche 1 bis 9, **dadurch gekennzeichnet, daß** die Schichtdicke der Isolatorschicht (5) etwa 0,1 µm beträgt.

11. SOI-IGBT nach einem der Ansprüche 1 bis 10, **dadurch gekennzeichnet, daß** in der Kanalzone (13) ein Kern (29) aus Metall oder polykristallinem Silizium enthalten ist.

12. Integrierte Schaltung mit einem SOI-IGBT nach einem der Ansprüche bis 11 und einer CMOS-Schaltung.

## Claims

1. SOI-IGBT, having a channel zone (13) of a first conductivity type, at least one cell zone (10) of a second conductivity type and at least one intermediate zone (15) of the first conductivity type, which intermediate zone partially delimits the IGBT, the channel zone (13), the cell zone (10) and the intermediate zone (15) being arranged in a silicon layer (9), which is applied on an insulator layer (5) provided on a semiconductor body (1) of the first conductivity type, in which the channel zone (13), the cell zone (10) and the intermediate zone (15) are connected to the semiconductor body (1) via corresponding cutouts (6, 7, 8) provided in the insulator layer (5).

2. SOI-IGBT according to Claim 1, **characterized by** a zone (12) of the second conductivity type which adjoins the cell zone (10) and is doped more weakly in comparison with the cell zone (10).

3. SOI-IGBT according to Claim 2, **characterized by** a field plate (19) arranged above the adjoining zone (12).

4. SOI-IGBT according to Claim 3, **characterized in that** the distance between the field plate (19) and the semiconductor body (1) increases continuously or in steplike fashion with increasing distance from an edge of the semiconductor body (1).

5. SOI-IGBT according to Claim 3 or 4, **characterized in that** a plurality of field plates (19) are provided.

6. SOI-IGBT according to one of Claims 1 to 5, **characterized by** an interruption (21) in the channel zone (13) which comprises a semiconductor zone of the first conductivity type.

7. SOI-IGBT according to Claim 2, **characterized in that** the distance (y) between the cutouts (7) of two adjacent cell zones (10) is less than the extent (x) of the adjoining zone (12).

8. SOI-IGBT according to one of Claims 1 to 7, **characterized in that** the semiconductor body is a silicon substrate (1) having a layer thickness of 100 to 500 µm.

9. SOI-IGBT according to one of Claims 1 to 8, **characterized in that** the layer thickness of the silicon layer (9) containing the channel zone (13), the cell zone (10) and the intermediate zone (15) is 0.1 to 5 µm.

10. SOI-IGBT according to one of Claims 1 to 9, **characterized in that** the layer thickness of the insulator layer (5) is approximately 0.1 µm.

11. SOI-IGBT according to one of Claims 1 to 10, **characterized in that** a core (29) made of metal or polycrystalline silicon is contained in the channel zone (13).

12. Integrated circuit having an SOI-IGBT according to one of Claims 1 to 11 and a CMOS circuit.

## Revendications

1. Transistor vertical bipolaire à grille isolée et structure du type silicium sur isolant, SOI-IGBT dans lequel :
- une zone de canal (13) présente un type de conductibilité,
- au moins une zone de cellule (10) présente l'autre type de conductibilité,
- au moins une zone intermédiaire (15) délimite en partie le transistor bipolaire et présente le premier type de conductibilité,
- la zone intermédiaire (15) se trouve dans une couche de silicium (9) déposée sur une couche isolante (5) prévue sur un corps semi-conducteur (1) du premier type de conductibilité,
- la zone de canal (13), la zone de cellule (10) et la zone intermédiaire (15) sont reliées au corps semi-conducteur (1) par des évidements (6, 7, 8) correspondants, prévus dans la couche isolante (5).

2. Transistor selon la revendication 1,
**caractérisé en ce qu'**
il comporte une zone (12) de l'autre type de conductibilité, située en limite de la zone de cellule (10) et qui, comparativement à celle-ci, est plus faiblement dopée.

3. Transistor selon la revendication 2,
**caractérisé en ce qu'**
il comporte une plaque de champ (19) montée sur la zone délimitante (12).

4. Transistor selon la revendication 3,
**caractérisé en ce que**
la distance entre la plaque de champ (19) et le corps semi-conducteur (1) croît constamment ou par degrés quand augmente la distance à un bord du corps semi-conducteur (1).

5. Transistor selon la revendication 3 ou 4,
**caractérisé par**
plusieurs plaques de champ (19).

6. Transistor selon une des revendications 1 à 5,
**caractérisé en ce que**
dans la zone de canal (13) une interruption (21) est constituée d'une zone semi-conductrice du premier type de conductibilité.

7. Transistor selon la revendication 2,
**caractérisé en ce que**
la distance (y) entre l'évidement (7) de deux zones de cellule (10) voisines est plus petite que l'étendue (x) de la zone (12) en limite.

8. Transistor selon une des revendications 1 à 7,
**caractérisé en ce que**
le corps semi-conducteur est un substrat de silicium (1) portant une couche d'une épaisseur de 100 à 500 µm.

9. Transistor selon une des revendications 1 à 8,
**caractérisé en ce que**
l'épaisseur de la couche de silicium (9) contenant la zone de canal (13), la zone de cellule (10) et la zone intermédiaire (15) est de 0,1 à 5 µm.

10. Transistor selon une des revendications 1 à 9,
**caractérisé en ce que**
l'épaisseur de la couche d'isolation (5) est d'environ 0,1 µm.

11. Transistor selon une des revendications 1 à 10,
**caractérisé en ce que**
la zone de canal (13) contient un noyau (29) en métal ou en silicium poly-cristallin.

12. Circuit intégré comprenant un transistor selon une des revendications 1 à 11, et un circuit CMOS.
